# FASCICULE DE BREVET EUROPEEN

(11) **EP 4 523 505 B1**
(45) Date de publication et mention de la délivrance du brevet: **06.05.2026**
(21) Numéro de dépôt: 23736240.5
(22) Date de dépôt: 20.06.2023
(51) Int. Cl.: H05K 7/20, H01Q 1/32

(54) **DISPOSITIF DE DISSIPATION THERMIQUE POUR UN CALCULATEUR ÉLECTRONIQUE**
WÄRMEABLEITUNGSVORRICHTUNG FÜR EINEN ELEKTRONISCHEN COMPUTER
HEAT DISSIPATION DEVICE FOR AN ELECTRONIC COMPUTER

(30) Priorité: 05.07.2022 FR 2206810
(43) Date de publication de la demande: 19.03.2025
(73) Titulaire: AUMOVIO Germany GmbH, 60488 Frankfurt am Main (DE)
(72) Inventeur: BEKAERT, Jean-Philippe, 31100 Toulouse (FR)
(74) Mandataire: Aumovio Corporation
(86) Numéro de dépôt international: PCT/EP2023/066687
(87) Numéro de publication internationale: WO 2024/008442

(56) Documents cités:
- EP-A1- 3 968 457
- EP-A1- 4 040 594
- EP-A2- 2 802 006
- WO-A1-2021/082962
- FR-A1- 3 115 501

## Description

### Domaine technique

L'invention appartient au domaine du contrôle thermique de dispositifs électronique et concerne en particulier un dispositif pour refroidir un dispositif électronique destiné à être intégré dans le toit d'un véhicule.

### Art antérieur

La plupart des véhicules modernes sont aujourd'hui configurés pour recevoir différents types de signaux radiofréquence. Ils sont par exemple configurés pour recevoir des signaux de radio numérique ou FM, des signaux transmis par des satellites de géolocalisation, établir des connexions Wi-Fi, Bluetooth, ou encore établir des communications au travers d'un réseau d'accès cellulaire. Ces technologies de communication n'opèrent pas dans les mêmes bandes de fréquences et nécessitent des configurations d'antennes et des démodulateurs spécifiques.

Afin d'en faciliter l'intégration dans un véhicule, ces technologies de communication sont le plus souvent intégrées dans un même dispositif, par exemple un TCU (Telecom Control Unit). Le TCU peut en outre intégrer les antennes nécessaires à la réception et à l'émission des signaux radiofréquence. On parle alors d'antenne intelligente (ou IAM pour Intelligent Antenna Module en anglais). Ce type d'antenne est généralement destiné à être intégré entre le ciel de toit et le toit du véhicule, les antennes faisant saillie au-dessus du toit au travers d'un orifice prévu à cet effet. Les antennes peuvent être recouvertes d'un capot, par exemple en forme d'aileron de requin.

Un tel module d'antenne intégré dans le toit est dès lors exposé à de fortes températures et à un risque d'infiltration d'eau par l'orifice pratiqué dans le toit au travers duquel les antennes font saillie. Le module doit en outre être compact pour s'intégrer entre le ciel de toit et le toit.

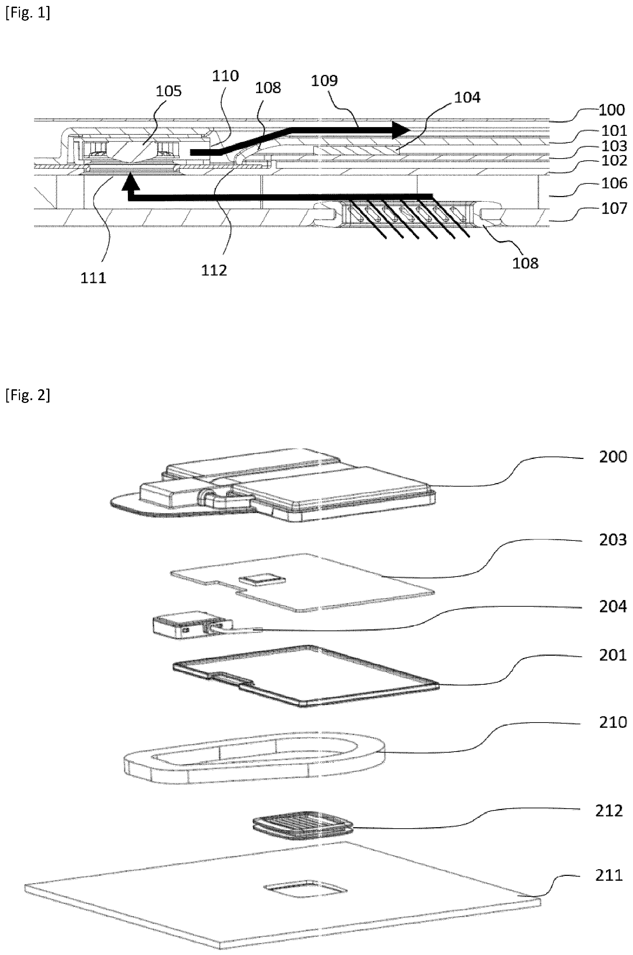

Afin de répondre à ces différentes contraintes, il a été proposé un module d'antenne de toit pour un véhicule tel que représenté sur la figure 1. Le module d'antenne comprend un châssis 101 et un capot 102 formant un boitier dans lequel est logé une carte électronique 103 et un ventilateur radial 105. Le châssis 101 est configuré pour former une rampe 108 disposée en regard d'un échappement latéral 110 du ventilateur 105 et configurée pour forcer un flux d'air 109 le long de la partie supérieure du châssis 101.

Le module d'antenne de la figure 1 est intégré entre un ciel de toit 107 et le toit 100 du véhicule. Un guide d'air 106 est intercalé entre le ciel de toit 107 et le capot inférieur 102 du module d'antenne, de sorte que l'air pénètre par une grille 108 avant d'être guidé par le guide 106 vers l'admission 111 du ventilateur 105, de sorte à créer un flux d'air parcourant la face inférieure et la face supérieure du module d'antenne pour refroidir des composants 104 de la carte électronique 103.

Afin de protéger le circuit électronique 103 en cas d'infiltration d'eau, il est prévu un joint 112. Le joint 112 permet d'éviter qu'un liquide s'écoulant sur la rampe 108 puisse atteindre la carte électronique 103.

Une telle configuration n'est pas entièrement satisfaisante.

En effet, implanter le joint 112 et le comprimer entraîne une perte de près de 25% de l'épaisseur disponible. Cela diminue d'autant la hauteur de rotor du ventilateur. Le volume d'air brassé par celui-ci est donc réduit et limite le ratio débit / bruit (un petit ventilateur doit tourner plus vite pour fournir le même débit).

L'installation du joint 112 nécessite d'augmenter la taille du capot et d'implanter des vis pour garantir sa compression et l'étanchéité. La masse du calculateur, son temps d'assemblage, son coût et sa masse sont élevés.

Ainsi, il existe un besoin pour un dispositif de dissipation thermique qui ne présente les inconvénients précités.

### Résumé de l'invention

A cet effet, il est proposé un dispositif de dissipation thermique pour un calculateur électronique comprenant un ventilateur radial logé dans l'épaisseur d'un boitier dudit calculateur et configuré pour faire circuler un flux d'air depuis une face inférieure du boitier vers le dessus du boitier par l'intermédiaire d'une rampe positionnée en vis-à vis de l'échappement du ventilateur.

Le dispositif est remarquable en ce que :
- La partie basse de la rampe est tronquée pour ménager un espacement entre ladite rampe et le ventilateur et permettre l'écoulement d'un liquide depuis une partie supérieure vers le dessous du boitier, et
- un déflecteur est positionné en sortie du ventilateur pour diriger le flux d'air vers ladite rampe.

Le déflecteur permet d'implanter un jeu afin d'éviter que l'eau ne pénètre dans le compartiment du circuit tout en limitant la recirculation de l'air entre l'échappement et l'admission par l'espacement ménagé entre la rampe et le ventilateur.

De cette façon, un liquide comme de l'eau de pluie peut s'écouler librement depuis la face supérieure du boitier vers le dessous du boitier sans qu'il soit nécessaire d'utiliser un joint. L'absence joint permet l'utilisation d'un ventilateur plus épais pouvant tourner plus lentement pour un débit équivalent. Le bruit est ainsi diminué. La taille du capot peut en outre être réduite, limitant ainsi la masse du calculateur. Enfin, l'assemblage du produit est plus simple et moins couteux.

Selon un mode de réalisation particulier, le déflecteur est formé par une partie du stator du ventilateur.

Le déflecteur est ainsi formé dans la matière du ventilateur. Son poids est ainsi limité et sa mise en place est facilitée.

Selon une réalisation particulière, le déflecteur est orienté pour diriger le flux d'air selon une direction sensiblement parallèle à la rampe.

En alignant le déflecteur avec la pente de la rampe, on limite encore la recirculation d'air et on améliore les performances de refroidissement.

### Brève description des figures

D'autres aspects, buts et avantages de l'invention apparaîtront à la lecture de la description suivante d'un de ses modes de réalisation, donné à titre d'exemple non limitatif. L'invention sera également mieux comprise en regard des dessins annexés sur lesquels :
La figure 1 est une vue en coupe d'un module d'antenne de l'art antérieur,
La figure 2 est une vue éclatée d'un module d'antenne selon une réalisation particulière de l'invention,
La figure 3 est une vue en coupe d'un module d'antenne selon une réalisation particulière,
La figure 4 est une vue en coupe d'un module d'antenne selon une réalisation particulière sur laquelle sont représentés des flux d'air.

### Description détaillée

La figure 2 est une vue éclatée d'un module d'antenne comprenant un dispositif de refroidissement selon un mode particulier de réalisation de l'invention. Le module d'antenne est par exemple installé dans le toit d'un véhicule, entre le ciel de toit et le toit.

Le module d'antenne comprend un boitier composé d'un châssis 200 et d'un capot inférieur 201 abritant une carte électronique 203 d'un calculateur. Le châssis est par exemple réalisé dans métal tel que de l'aluminium ou du magnésium.

Dans le but de refroidir la carte électronique 203, un ventilateur radial 204 est logé dans l'épaisseur du module d'antenne. Plus précisément, le ventilateur est placé dans un logement prévu à cet effet dans le châssis 200. Le ventilateur 204 et le logement dans lequel il est placé sont configurés pour aspirer l'air par le dessous du module d'antenne et le souffler par un échappement latéral sur la partie supérieure du châssis.

La figure 2 montre également un ciel de toit 211 muni d'une grille 212 destinée à permettre à l'air aspiré par le ventilateur de franchir le ciel de toit et circuler depuis la cabine du véhicule vers le dessus du châssis 200. Enfin, la figure 2 montre un guide d'air 210 disposé entre le dessous du module d'antenne et le ciel de toit 211 dont le but est d'une part d'éviter que le ciel de toit ne soit plaqué sur le ventilateur par l'aspiration, et d'autre part pour forcer une circulation d'air sur le dessous du boitier. Dans ce but, la grille d'aération 212 n'est pas placée à l'aplomb du ventilateur 204, mais sous le capot 201 de sorte que l'air aspiré est forcé de circuler le long du capot 201 avant de pénétrer dans le ventilateur 204. Ainsi, le guide d'air 210 intercalé entre le ciel de toit 211 et le dessous du module d'antenne permet de guider l'air qui pénètre par la grille 212 vers l'admission du ventilateur 204, de sorte à créer un flux d'air parcourant la face inférieure du module d'antenne pour refroidir la carte électronique 203.

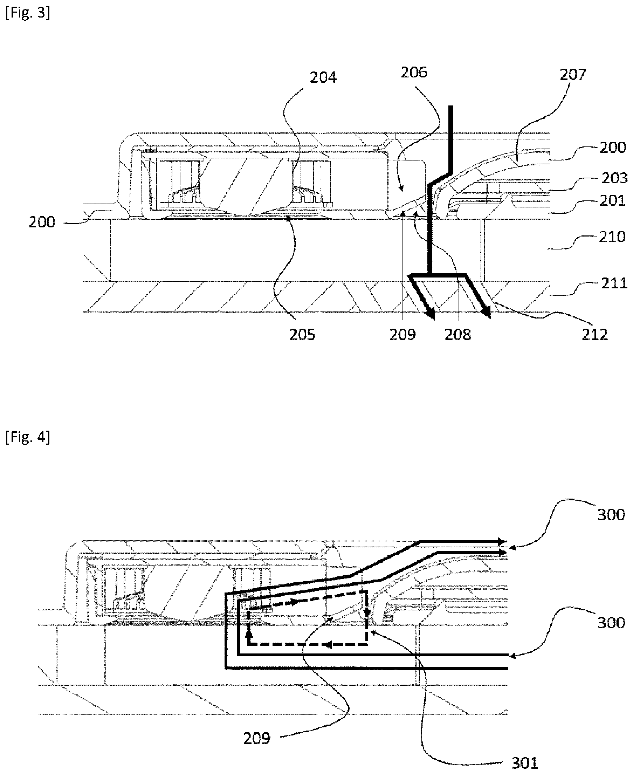

La figure 3 est une vue en coupe d'un module d'antenne selon une réalisation particulière. La figure 3 montre plus précisément la partie du module d'antenne dans laquelle est intégré le ventilateur 204. On précise que dans un souci de clarté, les mêmes références sur les figures sont utilisées pour désigner des éléments identiques.

La figure 3 montre l'admission 205 du ventilateur 204 sur la face inférieure du module d'antenne et l'échappement latéral 206 en direction d'une une rampe 207 formée par une partie du châssis 200 pour guider le flux d'air le long de la face supérieure du châssis.

Selon l'invention, la partie inférieure de la rampe 207 est tronquée de manière à ménager un espace 208 entre l'échappement 206 du ventilateur 204 et la rampe 207. Cette espace permet avantageusement à un liquide s'écoulant sur la rampe 207 de s'écouler vers le dessous du module d'antenne et la cabine par l'intermédiaire de la grille 212.

Dans un mode de réalisation particulier, l'extrémité inférieure de la rampe 207 forme une lèvre qui vient couvrir la tranche du capot 201 pour éviter qu'un liquide puisse s'infiltrer entre le châssis et le capot.

Pour éviter que l'air expulsé par le ventilateur ne soit détourné et aspiré au travers l'espacement 208, le dispositif comprend un déflecteur 209. Le déflecteur 209 configuré pour diriger le flux d'air sortant du ventilateur dans l'axe de rampe 207 et ainsi limiter la recirculation d'une partie du flux d'air au travers de l'espace 208 ménagé pour l'écoulement d'eau. Par exemple, la pente du déflecteur peut être sensiblement équivalente à la pente de la rampe pour minimiser l'angle d'incidence du flux d'air sur la rampe. Le rendement du ventilateur est ainsi amélioré et sa vitesse de rotation et/ou son gabarit peut être réduit par rapport à une configuration où le déflecteur serait absent.

Dans une réalisation particulière, le déflecteur est intégré au stator du ventilateur et réalisé dans la matière du ventilateur, par exemple dans une matière thermoplastique plus légère que le métal dont est constitué le châssis. Toutefois, selon d'autres modes de réalisation, le déflecteur est intégré au châssis et réalisé dans la matière du châssis.

La figure 4 est une vue en coupe d'un module d'antenne selon une réalisation particulière sur laquelle sont représentés des flux d'air. On observe un premier flux d'air principal 300 mis en circulation par le ventilateur. Le flux d'air 300 pénètre dans le ventilateur par la face inférieure du module d'antenne avant d'être dirigé par le déflecteur vers la rampe et la partie supérieure du boitier. On observe également une boucle de recirculation 301 très largement limitée par la présence du déflecteur 209.

Le dispositif de refroidissement proposé permet ainsi l'écoulement d'un liquide, par exemple l'écoulement d'eau de pluie infiltrée, depuis le dessus du module d'antenne jusqu'à l'habitacle sans qu'il soit nécessaire de prévoir un joint entre le capot et le châssis. L'espace libéré par l'absence de joint permet l'utilisation d'un ventilateur plus volumineux dont il est alors possible de réduire la vitesse de rotation, ce qui limite avantageusement le bruit et l'énergie consommée.

## Revendications

1. Dispositif de dissipation thermique pour un calculateur électronique comprenant un boitier composé d'un châssis (200) et d'un capot inférieur (201), un ventilateur radial (204) logé dans l'épaisseur du boitier, et une rampe (207) formée par une partie du châssis (200) positionnée en vis-à vis de l'échappement (206) du ventilateur (204), le ventilateur (204) étant configuré pour faire circuler un flux d'air depuis une face inférieure du boitier vers le dessus du boitier par l'intermédiaire de ladite rampe (207), le dispositif étant **caractérisé en ce que** :
- La partie basse de la rampe est tronquée pour ménager un espacement (208) entre ladite rampe et le ventilateur (204) et permettre l'écoulement d'un liquide depuis une partie supérieure vers le dessous du boitier, et
- un déflecteur (209) est positionné en sortie du ventilateur pour diriger le flux d'air vers ladite rampe (207).

2. Dispositif selon la revendication 1 tel que le déflecteur est formé par une partie du stator du ventilateur.

3. Dispositif selon l'une quelconque des revendications précédentes dans lequel le déflecteur est orienté pour diriger le flux d'air selon une direction sensiblement parallèle à la rampe.

4. Module d'antenne de toit pour un véhicule comprenant un dispositif de refroidissement selon l'une quelconque des revendications précédentes.

5. Véhicule comprenant un module d'antenne selon la revendication 4.

## Patentansprüche

1. Wärmeableitungsvorrichtung für einen elektronischen Computer, umfassend ein Gehäuse, das aus einem Rahmen (200) und einem unteren Deckel (201) besteht, ein in der Gehäusedicke untergebrachtes Radialgebläse (204) sowie eine durch einen Teil des Rahmens (200) gebildete Leiste (207), die gegenüber dem Auslass (206) des Gebläses (204) angeordnet ist, wobei das Gebläse (204) derart konfiguriert ist, dass es einen Luftstrom von einer Unterseite des Gehäuses zur Oberseite des Gehäuses über die genannte Leiste (207) leitet, und die Vorrichtung **dadurch gekennzeichnet ist, dass**:
- der untere Teil der Leiste abgeschrägt ist, um einen Abstand (208) zwischen der genannten Leiste und dem Gebläse (204) zu schaffen und den Durchfluss einer Flüssigkeit von einem oberen Bereich zur Unterseite des Gehäuses zu ermöglichen, und
- ein Abweiser (209) am Ausgang des Gebläses positioniert ist, um den Luftstrom zur genannten Leiste (207) zu lenken.

2. Vorrichtung nach Anspruch 1, **dadurch gekennzeichnet, dass** der Abweiser durch einen Teil des Stators des Gebläses gebildet ist.

3. Vorrichtung nach einer der vorhergehenden Ansprüche, wobei der Abweiser derart ausgerichtet ist, dass er den Luftstrom in einer im Wesentlichen parallel zur Leiste verlaufenden Richtung lenkt.

4. Dachantennenmodul für ein Fahrzeug, umfassend eine Kühlvorrichtung nach einem der vorhergehenden Ansprüche.

5. Fahrzeug, umfassend ein Antennenmodul nach Anspruch 4.

## Claims

1. A heat dissipation device for an electronic computer comprising a casing formed by a frame (200) and a lower cover (201), a radial fan (204) housed in the thickness of the casing, and a ramp (207) formed by a portion of the frame (200) positioned facing the outlet (206) of the fan (204), the fan (204) being configured to circulate an air flow from a lower face of the casing toward the top of the casing via said ramp (207), the device being **characterised in that**:
- the bottom portion of the ramp is truncated in order to form a spacing (208) between said ramp and the fan (204) and to enable a liquid to flow from an upper portion toward the bottom of the casing, and
- a deflector (209) is positioned at the outlet of the fan in order to direct the air flow toward said ramp (207).

2. The device according to claim 1, such that the deflector is formed by a portion of the stator of the fan.

3. The device according to any one of the preceding claims, wherein the deflector is oriented so as to direct the air flow in a direction substantially parallel to the ramp.

4. A roof antenna module for a vehicle comprising a cooling device according to any one of the preceding claims.

5. A vehicle comprising an antenna module according to claim 4.
